Europäisches Patentamt

European Patent Office

Office européen des brevets

(11) Veröffentlichungsnummer: **0 338 318**
**A1**

(12) **EUROPÄISCHE PATENTANMELDUNG**

(21) Anmeldenummer: **89105899.2**

(22) Anmeldetag: **04.04.89**

(51) Int. Cl.4: **H05K 7/14 , H01R 23/70**

(30) Priorität: **19.04.88 DE 8805197 U**

(43) Veröffentlichungstag der Anmeldung:
**25.10.89 Patentblatt 89/43**

(84) Benannte Vertragsstaaten:
**CH DE FR GB LI**

(71) Anmelder: **Siemens Aktiengesellschaft**
**Wittelsbacherplatz 2**
**D-8000 München 2(DE)**

(72) Erfinder: **Latussek, Hans-Peter, Dipl.-Ing.**
**Heideweg 77**
**D-8501 Feucht(DE)**
Erfinder: **Brune, Johannes, Dipl.-Ing.**
**Am Deckersweiher 4**
**D-8520 Erlangen(DE)**

(54) **Versteifungs- und Kodiervorrichtung.**

(57) Die Erfindung bezieht sich auf eine Versteifungs- und Kodiervorrichtung für eine gedruckte Leiterplatte (2) einer Steckbaugruppe, die mit wenigstens zwei beabstandeten Steckerleisten (4, 6) versehen ist. Erfindungsgemäß sind jeweils zwei beabstandete Steckerleisten (4, 6) über einen quaderförmigen mit hohem Widerstandsmoment versehenen Klotz (14) miteinander verbunden, wobei sich der Klotz (14) auf die Leiterplatte (2) und jeweils einen Befestigungsbereich (10, 12) einer Steckerleiste (6, 4) abstützt, und ist eine einer Front dieser Steckbaugruppe abgewandte Stirnseite des Klotzes (14) mit einer Aufnahme (18) für Mittel zur Zentrierung und Kodierung einer Steckbaugruppe versehen. Somit erhält man eine Versteifungs- und Kodiervorrichtung, die einerseits der Leiterplatte (2) eine erhöhte Festigkeit gegenüber Zug- oder Schubkräften verleiht und andererseits eine Kodierung der Leiterplatte beim erstmaligen Stecken zuläßt, wobei eine einfache Umkodierung möglich ist.

FIG 1

## Versteifungs- und Kodiervorrichtung

Die Erfindung bezieht sich auf eine Versteifungs- und Kodiervorrichtung für eine gedruckte Leiterplatte einer Steckbaugruppe, die mit wenigstens zwei beabstandeten Steckerleisten versehen ist.

Aus der DE 34 13 862 A1 ist eine Versteifung für eine gedruckte Leiterplatte bekannt, die als Rückwandverdrahtung zwischen beiden rückwärtigen Querschienen eines Baugruppenträgers eingesetzt ist. Dabei erstreckt sich wenigstens ein Steg von einer der beiden Querschienen zur anderen. Der Steg ist an mehreren Stellen mit der Leiterplatte formschlüssig verbunden, jedoch elektrisch von dieser Leiterplatte isoliert. Dadurch erhält man eine Versteifung für die gedruckte Leiterplatte, die zur Rückwandverdrahtung verwendet wird, wodurch die Leiterplatte eine ausreichende Festigkeit besitzt, insbesondere eine Festigkeit gegnüber Zug- oder Schubkräften, ohne daß sich dabei die Versteifung an die rückseitigen Querschienen des Baugruppenträgers abstützt.

Aus der DE 35 44 034 C2 ist eine Kodiervorrichtung bekannt, welche einen Einschub mit Schaltungseinheiten der elektrischen Nachrichtentechnik einer Einschubaufnahme eindeutig zuordnet. Dabei sind in den Frontbereichen von Einschub und Einschubaufnahme einander gegenüberliegende Öffnungen eingelassen. In einigen Öffnungen sind Stifte eingesetzt, welche beim Einstecken des Einschubs in die Aufnahme in die ihnen jeweils gegenüberliegenden Öffnungen hineingreifen. Diejenigen Öffnungen, in die keine Stifte hineingreifen sollen, sind mit Stöpseln verschlossen. Die mit Stöpseln verschließbaren Öffnungen weisen einen Anschlag auf, gegen den der in die Öffnung eingesetzte Stöpsel mit seiner in das Innere der Öffnung weisenden Stirnfläche stößt. Auf der Mantelfläche eines jeden Stöpsels ist mindestens ein verformbarer Steg vorhanden. Außerdem weist jede zur Aufnahme eines Stöpsels bestimmte Öffnung im hinteren Bereich vor dem Anschlag einen größeren Querschnitt auf als im vorderen Bereich. Dadurch ist erreicht worden, daß die Stöpsel einer Kodiervorrichtung große Kräfte aufnehmen können, wenn die Kodierstifte eines falschen Einschubs darauf treffen, wobei gleichzeitig eine einfache Umkodierung möglich ist.

Der Erfindung liegt nun die Aufgabe zugrunde, eine Versteifungs-und Kodiervorrichtung anzugeben, die einerseits der Leiterplatte eine erhöhte Festigkeit gegenüber Zug- oder Schubkräften verleihen soll und dabei platzsparend auf der Leiterplatte angebracht werden soll und die andererseits eine Kodierung der Leiterplatte zuläßt, wobei eine einfache Umkodierung möglich sein solle.

Die Aufgabe wird erfindungsgemäß dadurch gelöst, daß jeweils zwei beabstandete Steckerleisten über einen quaderförmigen mit einem hohen Widerstandsmoment versehenen Klotz miteinander verbunden sind, wobei sich der Klotz auf die Leiterplatte und jeweils einen Befestigungsbereich einer Steckerleiste abstützt, und daß eine einer Front dieser Steckbaugruppe abgewandte Stirnseite des Klotzes mit einer Aufnahme für Mittel zur Kodierung einer Steckbaugruppe versehen ist.

Dadurch, daß ein mit einem hohen Widerstandsmoment versehener Klotz als Verbindungselement zweier beabstandeter Steckerleisten vorgesehen ist, der einerseits sich auf die Leiterplatte und andererseits sich auf jeweils einen Befestigungsbereich der beabstandeten Steckerleisten abstützt, wird der Leiterplatte der Steckbaugruppe eine hohe Festigkeit verliehen. Dabei wird der Teil der Leiterplatte zwischen den beabstandeten Steckerleisten verwendet, der sowieso nicht von Bauteilen der Steckbaugruppe benutzt wird. Außerdem werden keine zusätzlichen Befestigungsvorrichtungen, beispielsweise Bohrlöcher benötigt, wodurch eine neue Entflechtung der Leiterplatte bzw. eine von Leiterplatte zu Leiterplatte unterschiedliche Befestigungsvorrichtung des Klotzes nicht notwendig ist. Der Klotz kann mit der Befestigungsschraube bzw. Befestigungsniete jeweils einer Steckerleiste beim Verschrauben bzw. beim Vernieten der Steckerleiste mit der Leiterplatte mit der Steckerleiste verschraubt bzw. vernietet werden. Somit ist der der Front der Steckbaugruppe abgewandte Kantenbereich mittels der beabstandeten Steckerleisten und der Versteifung gegenüber Zug-oder Schubkräften ausreichend gefestigt.

Gleichzeitig dient der Klotz als Halterung einer Aufnahme für Mittel zur Zentrierung und Kodierung der Leiterplatte bzw. Steckbaugruppe. Diese Aufnahme ist lösbar mit dem Klotz verbunden bzw. Bestandteil des Klotzes. Dadurch ist der Platz der Leiterplatte zwischen benachbarten Steckerleisten doppelt ausgenutzt. Wenn die Aufnahme mit dem Klotz lösbar verbunden ist, kann man die Aufnahme mit Mitteln zur Zentrierung und Kodierung einer Steckbaugruppe gegen eine andere Aufnahme mit anderen Mitteln zur Zentrierung und Kodierung der Steckbaugruppe ausgetauscht werden. Somit ist eine einfache Umkodierung einer Steckbaugruppe möglich.

Bei einer vorteilhaften Ausführungsform der Versteifungs- und Kodiervorrichtung ist der Klotz mit wenigstens einem Bügel versehen, der eine Steckerleiste umgreift und sich auf deren zweiten Befestigungsbereich abstützt und mit diesem lösbar verbunden ist. Dadurch wird die Festigkeit einer Leiterplatte wesentlich erhöht, die mit unterschiedlichen Steckerleisten, beispielsweise eine 64-polige und eine 96-polige Steckerleiste, versehen ist.

Bei einer weiteren vorteilhaften Ausführungsform der Versteifungs- und Kodiervorrichtung ist als Aufnahme für Mittel zur Kodierung einer Steckbaugruppe eine rechteckförmige Tragplatte vorgesehen, die mit einer beliebigen Anzahl von Öffnungen versehen ist, wobei die Tragplatte in zu einer Flachseite des Klotzes offenen Nuten geführt ist. Dadurch wird einerseits ein schneller Austausch einer Aufnahme mit Mitteln zur Kodierung einer Steckbaugruppe gewährleistet und andererseits bieten sich beliebig viele Kombinationsmöglichkeiten von Kodierstiften an, die in beliebig vielen Öffnungen der Tragplatte angeordnet werden können.

Mit einer weiteren vorteilhaften Ausführungsform der Versteigungs- und Kodiervorrichtung sind Kodierstifte derartig mit Rastmitteln versehen, daß sie beim erstmaligen Stecken der Steckbaugruppe in der Aufnahme des Klotzes oder in ihnen gegenüberliegende Öffnungen eines Gegenstücks einrasten. Durch diese Gestaltung der Kodierstifte beschränkt sich die Kodierung einer Steckbaugruppe darauf, daß die Kodierstifte mit den Rastmitteln oder um 180° gedreht in den Öffnungen der Aufnahme des Klotzes gesteckt werden, wodurch beim Stecken der Steckbaugruppe diese Kodierstifte in den Öffnungen der Aufnahme oder des Gegenstücks stecken bleiben. Beim Herausziehen der Steckbaugruppe bleiben die Kodierstifte, die mit der Aufnahme des Klotzes verrastet sind, in der Aufnahme stecken und die Kodierstifte, die mit den Öffnungen des Gegenstücks verrastet sind, im Gegenstück stecken. Somit ist die Kodierung dieser Steckbaugruppe beim erstmaligen Stecken in einen Baugruppenträger vorgenommen worden und bleibt bis zum Zeitpunkt einer eingeleiteten Änderung erhalten.

Zur weiteren Erläuterung der Erfindung wird auf die Zeichnung Bezug genommen, in der Ausführungsbeispiele nach der Erfindung schematisch veranschaulicht sind.

FIG 1 zeigt eine Sicht auf die Messer einer mit zwei Steckerleisten versehenen Leiterplatte mit einer dazwischen angeordneten erfindungsgemäßen Versteifungs- und Kodiervorrichtung, die

FIG 2 stellt eine erfindungsgemäße Versteifungs- und Kodiervorrichtung dar, in

FIG 3 ist eine Ansicht der Bauteileseite einer Leiterplatte mit zwei beabstandeten über eine vorteilhafte Versteifungs- und Kodiervorrichtung verbundenen Steckerleisten dargestellt, die

FIG 4 bis 7 zeigen unterschiedliche Kodierstifte und in den

FIG 8 bis 11 sind gleiche Kodierstifte mit jeweils einem Adapterstück veranschaulicht.

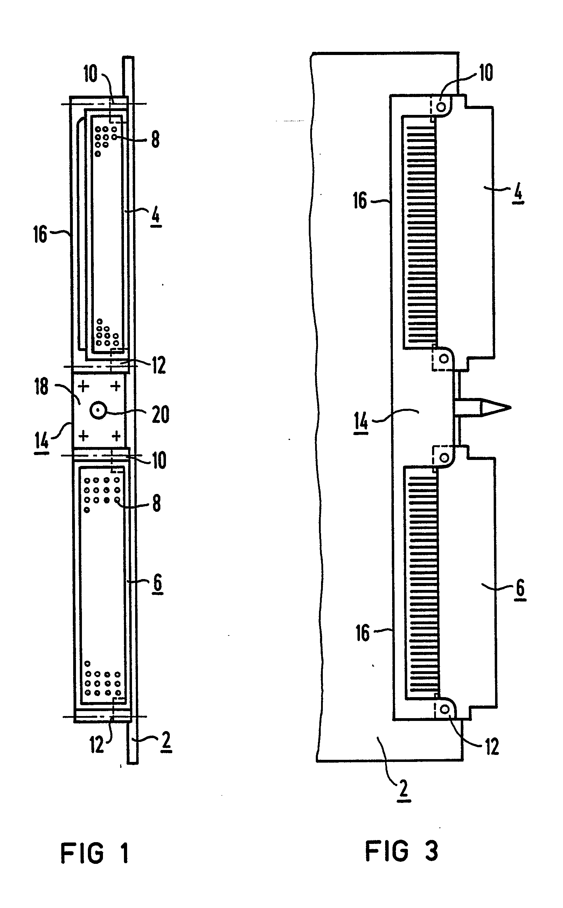

Die FIG 1 zeigt eine gedruckte Leiterplatte 2 einer Steckbaugruppe, wobei die Leiterplatte 2 mit zwei beabstandeten Steckerleisten 4 und 6 versehen ist. Dabei ist der Blick auf die Messer 8 der Steckerleisten 4 und 6 gerichtet. Als Steckerleiste 4 ist eine 64-polige Messerleiste und als Steckerleiste 6 ist eine 96-polige Messerleiste vorgesehen. Die Steckerleiste 4 bzw. 6 ist mit zwei Befestigungsschrauben, die der Übersichtlichkeit halber nicht dargestellt sind, mit zugehörigem Befestigungsbereich 10 und 12 mit der Leiterplatte 2 lösbar verbunden. Außerdem sind die beabstandeten Steckerleisten 4 und 6 mittels eines quaderförmigen Klotzes 14, der ein hohes Widerstandsmoment aufweist, miteinander verbunden. Dabei stützt sich dieser Klotz 14 auf die Leiterplatte 2 und jeweils auf einen Befestigungsbereich 12 der Steckerleiste 4 und einem Befestigungsbereich 10 der Steckerleiste 6 ab. Die Befestigungsschrauben dieser Befestigungsbereiche 12 und 10 verbinden mit den Steckerleisten 4 und 6 auch gleichzeitig den Klotz 14 mit der Leiterplatte 2. Der Klotz 14 kann aus Metall bzw. aus Aluminium gefertigt sein, wobei die Außenhaut des Klotzes 14 mit einer elektrisch isolierenden Hülle überzogen ist. Vorzugsweise ist der Klotz 14 aus einem Kunststoff gefertigt. Dieser Klotz 14 dient der Leiterplatte 2 als Versteifung. Außerdem ist der als Versteifung dienende Klotz 14 mit einem Bügel 16 versehen, der die Steckerleiste 4 umgreift. Ein dem Klotz 14 abgewandtes Ende des Bügels 16 stützt sich auf den freien Befestigungsbereich 10 der Steckerleiste 4 ab und ist ebenfalls mit einer Befestigungsschraube über den Befestigungsbereich 10 der Steckerleiste 4 mit der Leiterplatte 3 lösbar verbunden. Außerdem kann der Klotz 14 über einen freien Befestigungsbereich 10 der Steckerleiste 4 mittels einer Nietverbindung mit der Leiterplatte 2 verbunden werden. Da diese Leiterplatte 2 mit zwei Steckerleisten 4 und 6, deren Anzahl der Messer 8 unterschiedlich ist, versehen ist, treten auch unterschiedliche Zieh- und Steckkräfte an den entsprechenden Steckverbindern auf, die die Leiterplatte 2 unterschiedlich über die Gesamthöhe belasten. Durch den zusätzlichen Bügel 16 wird die Leiterplatte 2 zusätzlich versteift. Außerdem ist der Klotz 14 mit einer Aufnahme 18 mit einem Zentrierstift 20 versehen. Dabei ist die Aufnahme 18 mittels Schrauben, die aus Übersichtlichkeitsgründen nicht dargestellt sind, lösbar mit dem Klotz 14 verbunden. Der Zentrierstift 20 wird auch als Kodierung für eine Leiterplatte verwendet. Als Kodierschlüssel dient die Plazierung des Zentrierstiftes 20 auf der Aufnahme 18.

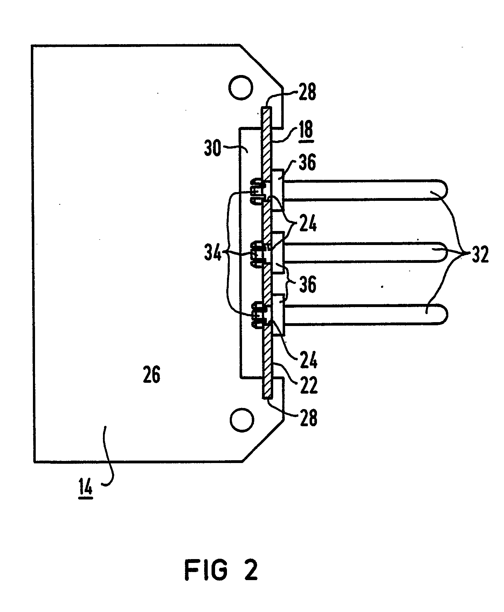

In FIG 2 ist eine als Versteifung einer gedruckten Leiterplatte 2 dienender Klotz 14 dargestellt. Bei diesem Klotz 14 ist als Aufnahme 18 für Mittel zur Zentrierung und Kodierung einer Steckbaugruppe eine rechteckförmige Tragplatte 22 vorgesehen, die eine beliebige Anzahl von Öffnungen 24 aufweist, von denen jedoch nur drei Öffnungen 24 dargestellt sind. Die Tragplatte 22 wird in zu einer Flachseite 26 des Klotzes 14 offenen Nuten 28 geführt, wodurch zwischen dem Klotz 14 und der Tragplatte 22 ein Freiraum 30 erzeugt ist. Als Mittel zur Kodierung der Steckbaugruppe sind Kodierstifte 32 vorgesehen, die in die Öffnungen 24 gesteckt sind. Jeder Kodierstift 32 ist mit einem Rastmittel 34 versehen, wobei dieses Rastmittel 34 an dem dem Freiraum 30 zugewandten Ende des Kodierstiftes 32 angeordnet ist. Außerdem hat jeder Kodierstift 32 einen Abstützring 36, wodurch jeweils der Kodierstift 32 mit Hilfe des Rastmittels 34 in der Öffnung 24 der Tragplatte 22 gehalten wird. Zum Umkodieren muß nur die Tragplatte 22 aus den Nuten 28 seitwärts herausgezogen werden. Bei herausgezogener Tragplate 22 kann die Anzahl der Kodierstifte 32 beliebig geändert werden oder die vorhandenen Kodierstifte 32 auf der Tragplatte 22 können umgesetzt werden.

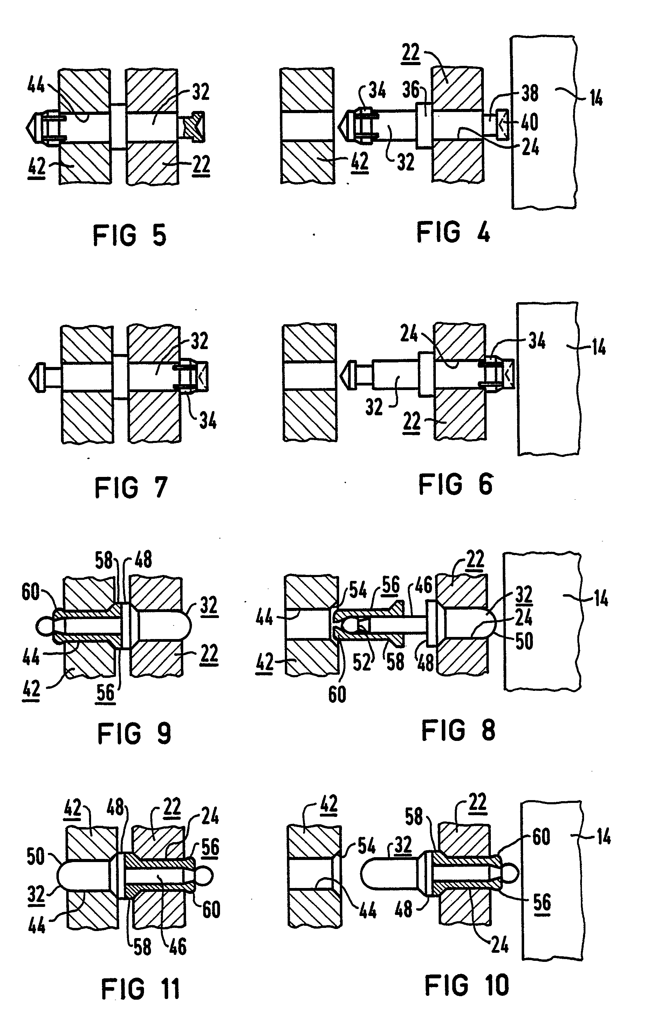

In FIG 3 ist eine Draufsicht einer Bauteileseite der Leiterplatte 2 einer Steckbaugruppe dargestellt. Bei dieser Ausführungsform des als Versteifung dienenden Klotzes 14 sind zwei Bügel 16 vorgesehen, die die Steckerleisten 4 und 6 jeweils umgreifen. Die freien Enden der Bügel 16 stützen sich jeweils auf die freien Befestigungsbereiche 10 bzw. 12 der Steckerleiste 4 bzw. 6 ab. Außerdem sind diese Enden der Bügel 16 jeweils mit einer Befestigungsschraube über den Befestigungsbereich 10 bzw. 12 der Steckerleiste 4 bzw. 6 mit der Leiterplatte 2 lösbar verbunden. Durch diese beiden Bügel 16 wird die Leiterplatte zusätzlich versteift.

In den FIG 4 und 5 ist jeweils ein Kodierstift 32 dargestellt, wobei in FIG 4 der Kodierstift 32 vor dem erstmaligen Stecken der Steckbaugruppe und in FIG 5 nach dem erstmaligen Stecken der Steckbaugruppe dargestellt ist. Als Kodierstift 32 ist ein Zylinderstift vorgesehen, der in einer Öffnung 24 der Tragplatte 22 steckt, wobei der Abstützring 36 auf der Tragplatte 22 aufliegt. Das Ende dieses Kodierstiftes 32, das dem Klotz 14 zugewandt ist, ist mit einer radial verlaufenden Nut 38 versehen, wobei dieses Ende stirnseitig mit einer kegelförmigen Ausnehmung 40 versehen ist. Das einem Gegenstück 42, das an einer Rückwandleiterplatte eines Baugruppenträgers angebracht ist, zugewandte Ende des Kodierstiftes 32 ist mit einem Rastmittel 34 versehen, wobei die Spitze dieses Endes kegelförmig geformt ist. Dieser Kodierstift 32 ist lose in die Öffnung 24 der Tragplatte 22 vor dem erstmaligen Stecken gesteckt. Die FIG 5 zeigt eine Lage des Kodierstiftes 32 nach dem erstmaligen Stek-

ken. Nachdem eine Steckbaugruppe, die mit einer Kodiervorrichtung gemäß FIG 2 mit nach FIG 4 dargestellten Kodierstiften 32 versehen ist, in einen Baugruppenträger gesteckt ist, rastet der Kodierstift 32 in eine Öffnung 44 des Gegenstücks 42 ein. Wenn nun die Steckgruppe aus dem Baugruppenträger wieder herausgezogen wird, bleibt der Kodierstift 32 im Gegenstück 42 stecken. Durch die Verwendung dieser Kodierstifte 32 wird beim erstmaligen Stecken dieser Steckbaugruppe eine Kodierung miterzeugt.

In den FIG 6 und 7 ist jeweils ein Kodierstift 32 dargestellt, wobei das Rastmittel 34 am Ende, das dem Klotz 14 zugewandt ist, angeordnet. Dadurch verrasten die Kodierstifte 32 mit der Tragplatte 22.

Zum Kodieren einer Steckbaugruppe werden in alle Öffnungen 24 der Tragplatte 22 des Klotzes 14 Kodierstifte 32 gemäß FIG 4 und FIG 6 gesteckt. Beim erstmaligen Stecken dieser Steckbaugruppe verrasten einige Kodierstifte 32 mit der Tragplatte 22 und einige Kodierstifte 32 mit dem Gegenstück 42. Dadurch ist die Kodierung der Steckbaugruppe abgeschlossen.

In den FIG 8 und 9 ist eine weitere Ausführungsform des Kodierstiftes 32 dargestellt, wobei in FIG 8 der Kodierstift 32 vor dem erstmaligen Stecken und in FIG 9 nach dem erstmaligen Stecken dargestellt ist. Als Kodierstift 32 ist ein Zylinderstift vorgesehen, der zwei unterschiedliche Durchmesser hat, wobei der Teil 46 des Zylinderstiftes mit dem kleineren Durchmesser über einen Absatz 48 in den Teil 50 des Zylinderstiftes mit dem größeren Durchmesser übergeht. Das Ende des Teils 46 des Zylinderstiftes ist mit einer radial angeordneten Kerbe 52 versehen. Der Übergang des Teils 50 des Zylinderstiftes zum Absatz 48 ist als kontinuierlicher Übergang gestaltet. Dadurch ist die entsprechende Öffnung 24 in der Tragplatte 22 mit einer Senke 54 versehen. Die dieser Öffnung 24 gegenüberliegende Öffnung 44 des Gegenstücks 42 entspricht genau der Öffnung 24. Der Teil 46 des Zylinderstiftes ist in FIG 8 mit einem Adapterstück 56 versehen, wobei ein Ende des Adapterstückes 56 als einen Absatz 58 und ein anderes Ende als Rastmittel 60 ausgestaltet ist. Der Außendurchmesser entspricht dem Durchmesser der Öffnung 24 oder 44 und der Innendurchmesser entspricht dem Durchmesser des Teils 46 des Zylinderstiftes.

In den FIG 10 und 11 ist der Kodierstift 32 um 180° gedreht angeordnet, wodurch nach dem erstmaligen Stecken der Steckbaugruppe die Kodierstifte 32 in Öffnungen 24 der Tragplatte 22 des Klotzes 14 stecken bleiben.

Wenn nun eine Steckbaugruppe kodiert werden soll vor dem erstmaligen Stecken, so werden eine Anzahl von Kodierstiften 32 mit dem Teil 50 des Zylinderstiftes in beliebige Öffnungen 24 der Tragplatte 22 des Klotzes 14 gesteckt. Auf den Teil 46 der Zylinderstifte werden die Adapterstücke 56 geschoben wie in FIG 8 dargestellt. Außerdem werden die restlichen Öffnungen 24 der Tragplatte 22 mit Kodierstiften 32 gemäß FIG 10 versehen. Beim Einschieben der Steckbaugruppe in einen Baugruppenträger werden die Adapterstücke 56 mit dem Teil 46 der Zylinderstifte in ihnen gegenüberliegende Öffnungen 44 des Gegenstücks 42 gesteckt. Durch weiteres Stecken der Steckbaugruppe bis zur Endlage bleibt das Adapterstück 46 infolge des Absatzes 58 in der Öffnung 44 bzw. 24 ortsfest liegen, wogegen der Teil 46 des Zylinderstiftes sich noch weiterbewegt, bis der Absatz 48 des Kodierstiftes 32 sich auf den Absatz 58 des Adapterstückes 56 abstützt. Zu diesem Zeitpunkt hatte das Ende des Teils 46 des Zylinderstiftes das Rastmittel 60 des Adapterstücks 56 geweitet, wodurch das Rastmittel 60 danach in der Kerbe 52 des Teils 46 des Zylinderstifts einrasten konnte. Mit Hilfe dieses Adapterstückes 56 ist der Kodierstift 32 in der Öffnung 44 bzw. 24 des Gegenstücks 42 bzw. der Tragplatte 22 verankert, wodurch beim Herausziehen der Steckbaugruppe die Kodierstifte im Gegenstück 42 bzw. in der Tragplatte 22 stecken bleiben. Somit wird beim erstmaligen Stecken einer Steckbaugruppe gleichzeitig die Kodierung dieser Steckbaugruppe erzeugt.

**Ansprüche**

1. Versteifungs- und Kodiervorrichtung für eine gedruckte Leiterplatte (2) einer Steckbaugruppe, die mit wenigstens zwei beabstandeten Steckerleisten (4, 6) versehen ist, **dadurch gekennzeichnet,** daß jeweils zwei beabstandete Steckerleisten (4, 6) über einen quaderförmigen mit hohem Widerstandsmoment versehenen Klotz (14) miteinander verbunden sind, wobei sich der Klotz (14) auf die Leiterplatte (2) und jeweils einen Befestigungsbereich (10, 12) einer Steckerleiste (6, 4) abstützt, und daß eine einer Front dieser Steckbaugruppe abgewandte Stirnseite des Klotzes (14) mit einer Aufnahme (18) für Mittel zur Zentrierung und Kodierung einer Steckbaugruppe versehen ist.

2. Versteifungs- und Kodiervorrichtung nach Anspruch 1, **dadurch gekennzeichnet,** daß der Klotz (14) mit wenigstens einem Bügel (16) versehen ist, der eine Steckerleiste (4, 6) umgreift und sich auf deren zweiten Befestigungsbereich (10, 12) abstützt und mit diesem lösbar verbunden ist.

3. Versteifungs- und Kodiervorrichtung nach Anspruch 1, **dadurch gekennzeichnet,** daß als Aufnahme (18) für Mittel zur Zentrierung und Kodierung eine rechteckförmige Tragplatte (22) vorgesehen ist, die mit einer beliebigen Anzahl von Öffnungen (24) versehen ist, wobei die Tragplatte (22) in zu einer Flachseite (26) des Klotzes (14) offenen Nuten (28) geführt ist.

4. Versteifungs- und Kodiervorrichtung nach Anspruch 1, **dadurch gekennzeichnet,** daß als Mittel zur Zentrierung und Kodierung ein Zentrierstift (20) vorgesehen ist, der an eine vorbestimmte Stelle der Aufnahme (18) angeordnet ist.

5. Versteifungs- und Kodiervorrichtung nach Anspruch 1 und 3, **dadurch gekennzeichnet,** daß als Mittel zur Zentrierung und Kodierung eine beliebige Anzahl von Kodierstiften (32) vorgesehen ist, die in Öffnungen (24) der Aufnahme (18) gesteckt sind.

6. Versteifungs- und Kodiervorrichtung nach Anspruch 5, **dadurch gekennzeichnet,** daß die Kodierstifte (32) derartig mit Rastmitteln (34) versehen ist, daß sie beim erstmaligen Stecken der Steckbaugruppe in der Aufnahme (18) des Klotzes (14) oder in ihnen gegenüberliegende Öffnungen (44) eines Gegenstücks (42) einrasten.

7. Versteifungs- und Kodiervorrichtung nach Anspruch 5, **dadurch gekennzeichnet,** daß die Kodierstifte (32) jeweils mit einem Adapterstück (56) versehen sind.

**FIG 1**

**FIG 3**

FIG 2

FIG 5

FIG 4

FIG 7

FIG 6

FIG 9

FIG 8

FIG 11

FIG 10

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4 ) |
|---|---|---|---|
| Y | US-A-4568134 (DI MONDI)<br>* Spalte 2, Zeile 29 - Spalte 3, Zeile 63 *<br>--- | 1 | H05K7/14<br>H01R23/70 |
| Y | FR-A-2363963 (ERICSSON)<br>* Seite 2, Zeile 18 - Zeile 33 *<br>--- | 1 | |
| A | FR-A-2534109 (KARL HEHL)<br>* Seite 5, Zeile 3 - Zeile 36 *<br>--- | 1-2 | |
| A | GB-A-2166301 (SMITHS)<br>* Seite 2, Zeile 70 - Zeile 129 *<br>--- | 4-6 | |
| A,D | DE-A-3413862 (SIEMENS)<br>--- | | |
| A,D | DE-A-3544034 (ANT)<br>----- | | |
| | | | **RECHERCHIERTE SACHGEBIETE (Int. Cl.4 )**<br><br>H05K<br>H01R |

Der vorliegende Recherchenbericht wurde für alle Patentansprüche erstellt

| Recherchenort<br>**DEN HAAG** | Abschlußdatum der Recherche<br>**25 MAI 1989** | Prüfer<br>**TOUSSAINT F.M.A.** |
|---|---|---|

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
........................................................
& : Mitglied der gleichen Patentfamilie, übereinstimmendes Dokument

EPO FORM 1503 03.82 (P0403)